# EUROPEAN PATENT SPECIFICATION

(11) **EP 0 371 459 B1**
(45) Date of publication and mention of the grant of the patent: **05.07.1995**
(21) Application number: 89121936.2
(22) Date of filing: 28.11.1989
(51) Int. Cl.: G11C 7/00, G11C 11/409

(54) **Semiconductor memory device provided with an improved common data line precharge circuit**
Speicherschaltung mit einer verbesserten Vorladungsschaltung für gemeinsame Datenleitung
Dispositif de mémoire pourvu d'un circuit de précharge à ligne de données commune

(30) Priority: 28.11.1988 JP 299965/88
(43) Date of publication of application: 06.06.1990
(73) Proprietor: NEC CORPORATION, Tokyo (JP)
(72) Inventor: Nakada, Kazuhiro c/o NEC Corporation, Minato-ku Tokyo (JP)
(74) Representative: Glawe, Delfs, Moll & Partner

(56) References cited:
- EP-A- 0 261 609
- EP-A- 0 262 531
- IEEE JOURNAL OF SOLID-STATE CIRCUITS. vol. SC-22, no. 5, October1987, NEW YORK US pages 657 - 662; KITSUKAWA ET AL.: 'AN EXPERIMENTAL 1-MBIT BICMOS DRAM'

## Description

### Field of the Invention:

The present invention relates to a semiconductor memory device and more particularly to a semiconductor memory device in which a plurality of bit lines and a pair of common data lines are precharged prior to each access operation.

### Description of the Related Arts:

Semiconductor memory devices such as dynamic type memory devices employing the so-called one-transistor memory cells have been widely used in various fields as large capacity memories. A conventional memory device is constructed as follows. A plurality of memory cells are arranged in a matrix form of rows and columns and, a plurality of word lines and a plurality of pairs of bit lines are arranged in the rows and columns, respectively. A plurality of sense amplifiers are provided for the pairs of bit lines, respectively. For performing a column selection, a plurality of transfer gate transistors are coupled between the pairs of bit lines and a pair of common data lines. In operation, the pairs of bit lines and the pair of common data lines are precharged prior to each access operation. After an access operation is initiated, one of word lines is selected and small potential difference is produced between each pair of bit lines. Then, the sense amplifiers are enabled to amplify small potential differences in the respective pairs of bit lines gradually, while one pair of the transfer gate transistors are selectively rendered conductive. As a result, one pair of bit lines are electrically connected to the pair of common data lines, and a read-out signal at the selected pair of bit lines is transmitted to the pair of common data lines. Since each pair of bit lines have been precharged approximately at an intermediate voltage of 1/2 Vcc (Vcc: a value of power voltage), the levels of each pair of bit lines are near the intermediate voltage with a small signal difference before completion of amplification operation by the sense amplifiers. While the pair of common data lines are precharged to the power voltage Vcc. Therefore, at the time when the selected pair of bit lines are electrically connected to the pair common data lines, large amount of electric charges flow into the selected pair of bit lines from the pair of common data lines to affect the potentials of the selected pair of bit lines. Particularly, in the case where the selected pair of transfer gate transistors have different values of effective conductive-resistances, the electrical charges at the pair of common data lines are flown unequally into the selected pair of bit lines. In this case, if one of the selected pair of bit lines assumes a relatively high potential and connected to one transfer gate transistor having a relatively large conductive-resistance while the other bit line assumes a relatively low potential and connected to the other transfer gate transistor having a relatively small conductive-resistance, the above one bit line and the other bit line would erroneously take low and high levels, respectively by electric charges flown unequally thereinto if the selected pair of transfer gate transistors are rendered conductive before the completion of the amplifying operation by the sense amplifiers. Thus, the disadvantage of the conventional memory device is that data stored in the memory cell may be destroyed upon a reading operation. An example of an arrangement, in which the data lines are precharged to Vcc/2, is shown in EP-A-0 261 609.

### SUMMARY OF THE PRESENT INVENTION

It is an object of the present invention to provide a semiconductor memory device which has an improved precharge arrangement.

A semiconductor memory device according to the present invention is specified in Claim 1.

### BRIEF DESCRIPTION OF THE DRAWINGS

The above and further objects, features and advantages of the present invention will become more apparent from the following detailed description taken in conjunction with rhe accompanying drawings, wherein:
Fig. 1 is a schematic block diagram showing a semiconductor memory device in the prior art;
Fig. 2 is a timing diagram showing a normal operation of the memory device of Fig. 1;
Fig. 3 is a timing diagram showing an erroneous operation of the memory device of Fig. 1;
Fig. 4 is a schematic block diagram of the memory device according to one embodiment of the present invention;
Fig. 5 is a timing diagram showing an operation of the memory device of Fig. 4;
Fig. 6 is a schematic block diagram of a memory device according to another embodiment of the present invention; and
Fig. 7 is a timing diagram showing an operation of the memory device of Fig. 6.

### DETAILED DESCRIPTION OF THE INVENTION

### Description of the Prior Art:

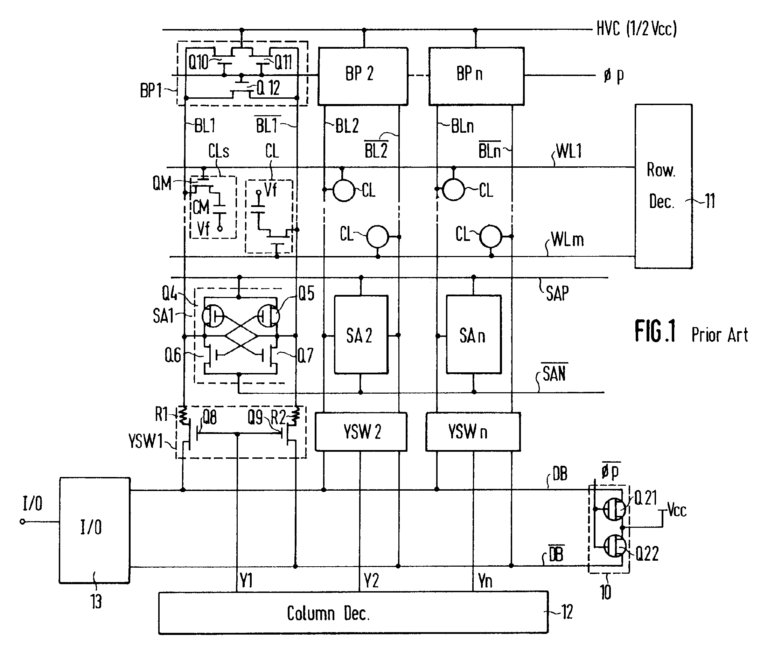

With reference to Fig. 1, a semiconductor memory device in the prior art will be explained.

As shown in Fig. 1, m word lines WL1 - WLm and n pairs of bit lines BL1, B̅L̅1̅-BLn, B̅L̅n̅ are arranged in the form of a matrix of rows and columns. Dynamic type memory cells CL are disposed at the intersections of the word lines and the bit lines in a known way.

Bit line balance-precharge circuits BP1 - BPn are disposed at one ends of the respective pairs of the bit lines BL1, B̅L̅1̅ - BLn, B̅L̅n̅, whereas transfer switches YSW1 - YSWn connected to a pair of common data lines DB, D̅B̅ are disposed at the other ends of the respective pairs of bit lines, as illustrated. Each of the transfer switches YSW1 - YSWn includes N-channel MOS transistors Q₈ and Q₉ and is capable of switching operation for making and breaking the connection electrically between each of the sense amplifiers SA1 - SAn and the data lines in accordance with column selection signals Y₁ - Yₙ from a column decoder 12. Each of the differential sense amplifiers SA1 - SAn includes P-channel transistors Q₄ and Q₅ and N-channel transistors Q₆ and Q₇ and, is driven by a pair of sense control signals SAP, S̅A̅N̅.

The data lines DB, D̅B̅ are precharged by a balance-precharge circuit 10 having P-channel MOS transistors Q₂₁ and Q₂₂ which are turned on by a low level of a precharge signal φ̅_̅{̅P̅}̅ so that both DB and D̅B̅ are precharged at a power voltage Vcc.

A voltage line HVC provided with a precharge potential of 1/2 Vcc is applied to each of the bit line balance-precharge circuits BP1 - BPn. A row decoder 11 selects one of the word lines WL1 - WLn, and an input/output circuit 13 connected to an I/O terminal I/O is coupled to the pair of data lines DB and D̅B̅ in a known way.

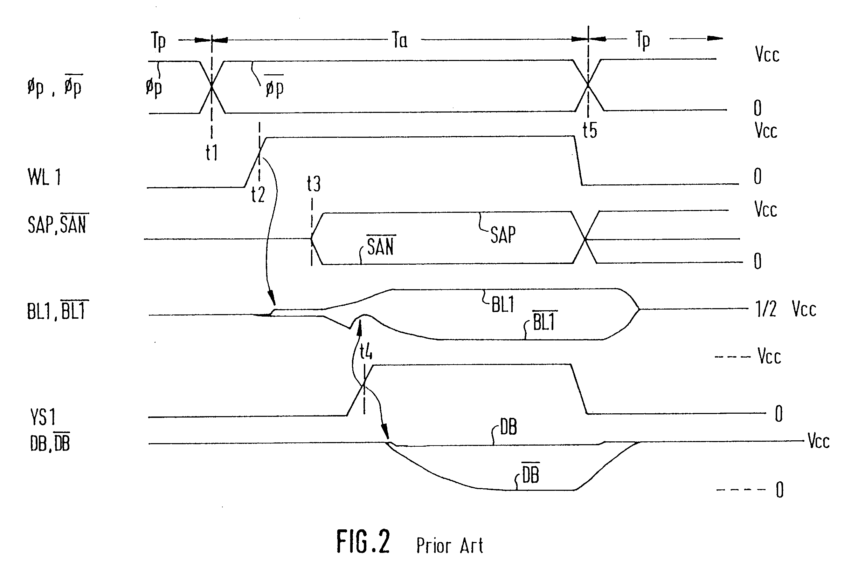

Referring to Fig. 2, the operation of the memory of Fig. 1 will be explained.

During a precharge period T_{P} prior to a time point t₁, the precharge signal φ_{P} and φ̅_̅{̅P̅}̅ are at a high level and a low level, respectively. Therefore, the transistors Q₁₀ - Q₁₂ of the respective precharge circuits BP1 - BPn are all conductive to precharge the respective pairs of bit lines to the 1/2 Vcc level in response to the high level of φ_{P}, while the transistors Q₂₁ and Q₂₂ of the precharge circuit 10 are conductive in response to the low level of φ̅_̅{̅P̅}̅ thereby to precharge the pair of data lines DB and D̅B̅ at the Vcc level. Then, at t₁, an active period Ta is initiated, and the precharge circuits BP1 - BPn and 10 are disenabled. At a time point t₂, one of the word lines, e.g. WL1 is selected to be a high level. In this case, the memory cell CLs coupled to the selected word line WL1 and the bit line BL1 is selected. Assuming that the memory cell CLs stores "1" level at its capacitor CM coupled between a cell transistor Q_{M} and a fixed potential V_{f}, the bit line BL1 is raised slightly in potential while the bit line B̅L̅₁̅ remains at the precharge level (1/2 Vcc).

When the signal SAP becomes high simultaneously with the signal line S̅A̅N̅ being set low at a time point t₃, the sense amplifiers SA1 - SAn amplify the potential difference of the respective bit lines.

When the column selection signal Y1 becomes high at a time point t₄, the bit lines BL1, B̅L̅1̅ and the data lines DB, D̅B̅ are electrically connected through YSW1. Although the potential of the bit lines BL1 rises temporarily because of the injection of charge from the data line D̅B̅, the potential together with that of the data line DB is gradually set to the ground level (GND). Although the potential of the data line DB becomes lower in level than Vcc when electrically connected to the bit line BL1, the electrical connection of the bit line BL1 with the data line DB accelerates a rise in its potential. When the potential level of the bit line BL1 becomes lower than Vcc by the threshold voltage VT of the N-channel MOS transistor Q₈, the transistor Q₈ is turned off and the potential level of the data line DB is stopped from decreasing. The data (charge) stored in the memory cell CLs through a series of the aforementioned operations is amplified by the sense amplifier SA1 and supplied to the data lines DB, D̅B̅.

Then, at a time point t₅, the active period is terminated.

In the aforementioned conventional semiconductor memory device, the potential of the data lines is precharged at Vcc.

The potential of the column selection signal Y1 is set high while the difference in potential between the bit lines BL1 and B̅L̅1̅ remains small. While storay resistors R1 and R2 are inevitably provided to the current paths of the transistors Q₈ and Q₉. If the resistance of the resistor R1 becomes abnormally higher by approximately 50% than the on-resistance of the transistor Q₈ due to deviations or deformities of the production system. While the resistance of R2 is normal (R1 > R2), the electrical connection of the bit line BL1 with the data line DB is apparently weakened as compared to that through R2, a rise in the potential of the bit line BL1 relies on only the amplification capability of the sense amplifier SA1.

Regarding the bit line B̅L̅1̅, its electrical connection with the data line D̅B̅ results in a potential rise.

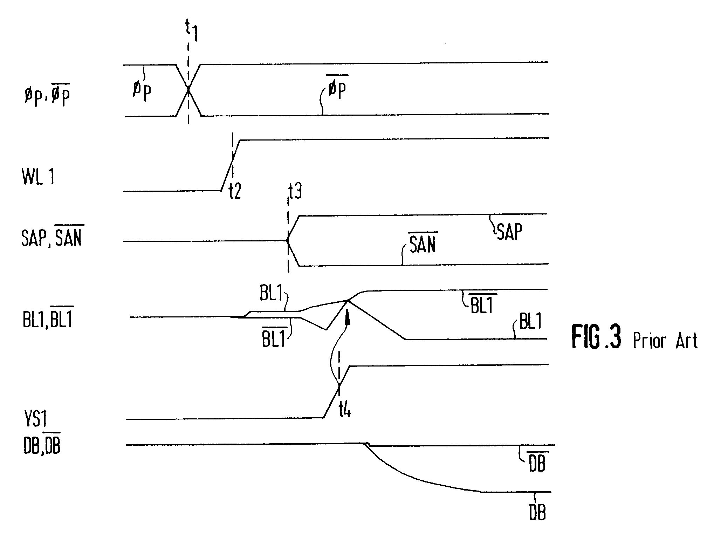

If the potential of the column selection signal Y1 is set high while the difference in potential between the bit lines BL1 and B̅L̅1̅ is insufficiently great, the potential is inverted at the time point t₄ as shown in Fig. 3 and the bit line B̅L̅1̅ becomes high, whereas the bit line BL1 becomes low. The disadvantage is that the data stored in the memory cell may be destroyed.

### Description of the Embodiments:

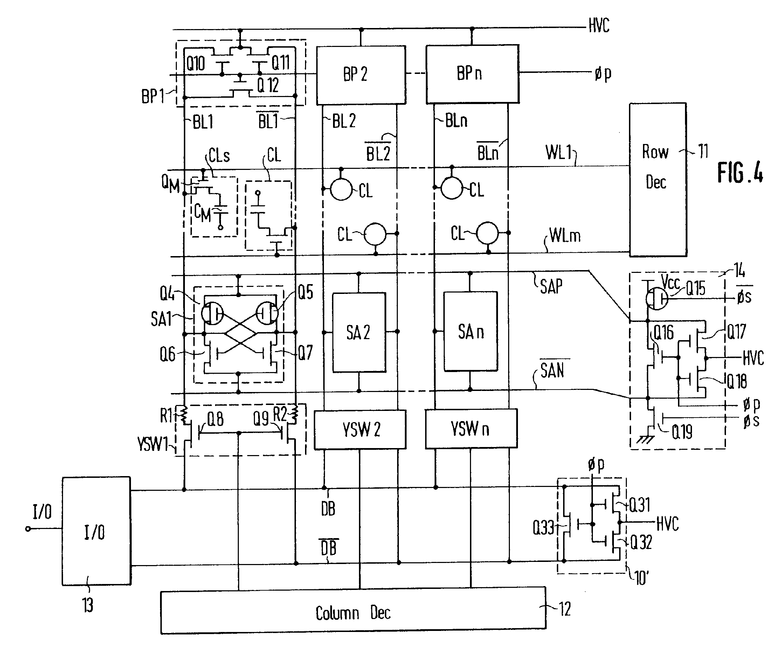

With reference to Fig. 4, the semiconductor memory device according to one preferred embodiment will be explained.

In the following drawings, the elements or portions corresponding to those in Fig. 1 are denoted by the same or similar references, and detailed explanation thereon would be omitted.

The memory device of this embodiment is basically obtained by employing a data line precharge circuit 10′ in place of the precharge circuit 10 of Fig. 1. The precharge circuit 10′ includes N-channel transistors Q₃₁ - Q₃₃ and operatively charges the pair of data lines DB and D̅B̅ to the 1/2 Vcc level supplied to the line HVC in response to the high level of φ_{P}.

A control circuit 14 includes P-channel MOS transistor Q₁₅ and N-channel MOS transistors Q₁₆ - Q₁₉. The control circuit 14 generates the 1/2 Vcc level of SAP and S̅A̅N̅ in response to the high level of φ_{P} through the transistors Q₁₆ - Q₁₈ prior to a time point t₃ and, the high level Vcc of SAP and the low level(GND) of S̅A̅N̅ in response to the high level of φ_{S} and the low level of φ̅_̅{̅S̅}̅ in the active period after a time point t₃. Namely, the control circuit 14 generates the 1/2 Vcc level of SAP and S̅A̅N̅ for precharging the respective nodes of the sense amplifiers SA1 - SAN in the precharge period and the Vcc level of SAN and the ground level of S̅A̅P̅ for enabling the sense amplifiers in the active period.

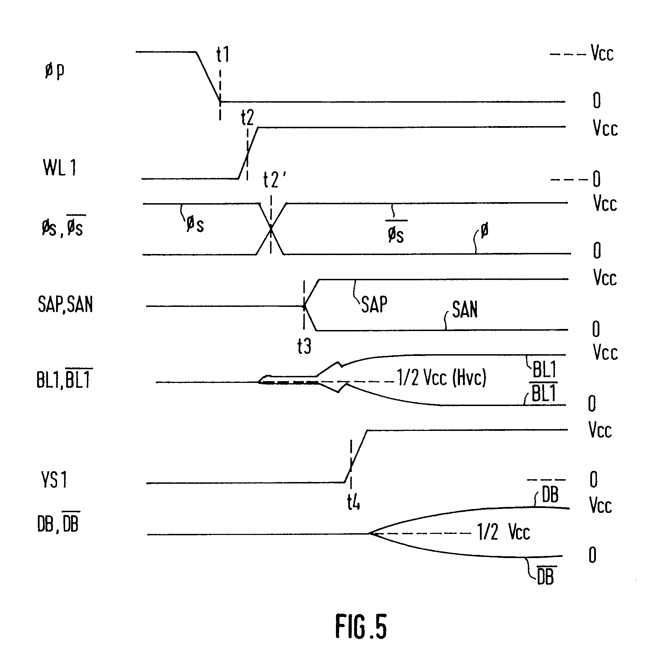

As will readily be understood from Figs. 4 and 5, the potential of the data lines is balance-precharged at 1/2 Vcc with the potential of φ_{P} kept high, whereas the bit line is precharged also at 1/2 Vcc with the potential of the signal line φ_{P} kept high. The potential of the signal φ_{P} is, set low before the potential of the word line WL1 becomes high at t₂. After t₃, the control circuit 14 generates the Vcc level of SAP and the GND level of S̅A̅N̅. As a result, the sense amplifiers SA1 - SAN are supplied with the Vcc level of SAN and the GND level of S̅A̅P̅ as operating voltages so that one bit line having a high level and the other bit line having low level in each bit line pair are amplified to the Vcc level and the GND level gradually. The similar operation as that of the conventional example is performed until the potential of the column selection signal Y1 becomes high at t₄. When the potential of the column selection signal Y1 becomes high, the pair of data lines DB, D̅B̅ are electrically connected to the respective bit lines BL1 and B̅L̅1̅ at t₄. The bit line BL1 temperarily falls to the potential of the data line DB, whereas the bit line B̅L̅1̅ temporarily rises to the potential of the data line D̅B̅, at t₄.

There is also produced the difference in potential between the pair of data lines DB, D̅B̅ because the potential difference between the bit lines BL1, B̅L̅1̅ tends to grow because of the amplification capability of the sense amplifier SA1.

When the potential of the column selection signal Y1 becomes high while the difference in potential between the bit lines is not sufficiently great with the resistance of the resistor R1 being high, the potential of the bit line BL1 is kept from decreasing to the value shown in Fig. 5 because of the action of the resistor R1. Although the potential of the bit line B̅L̅1̅ is temporarily caused to rise up to that of I/O line likewise as shown in Fig. 5, it remains lower than 1/2 Vcc.

As a result, the potential of the bit line BL1 becomes higher than that of the bit line B̅L̅1̅, so that the data stored in the memory cell CLS is never destroyed.

Although a description has been made of the bit line BL1, the same process is applicable to the other pairs of bit lines.

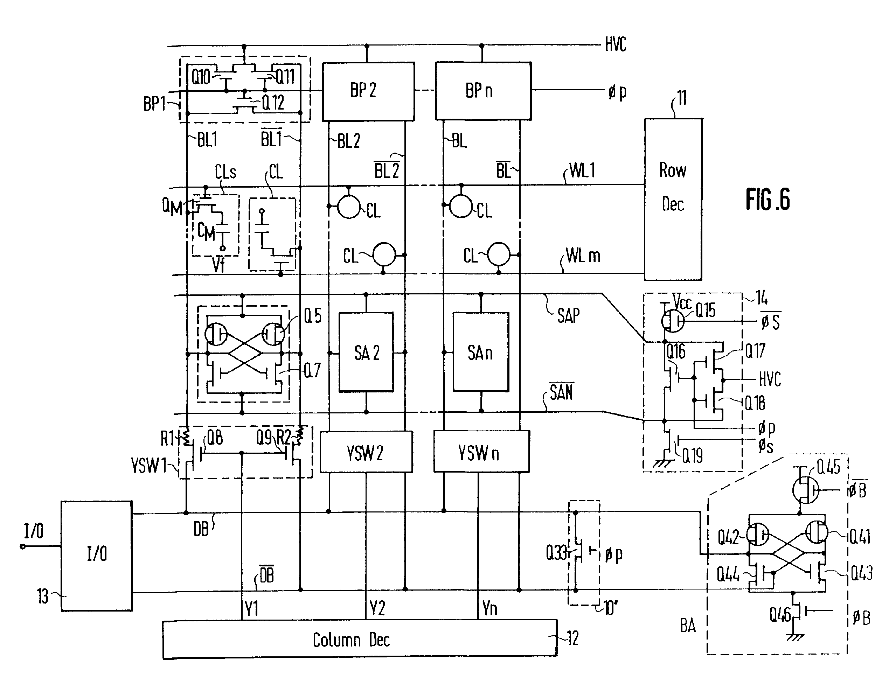

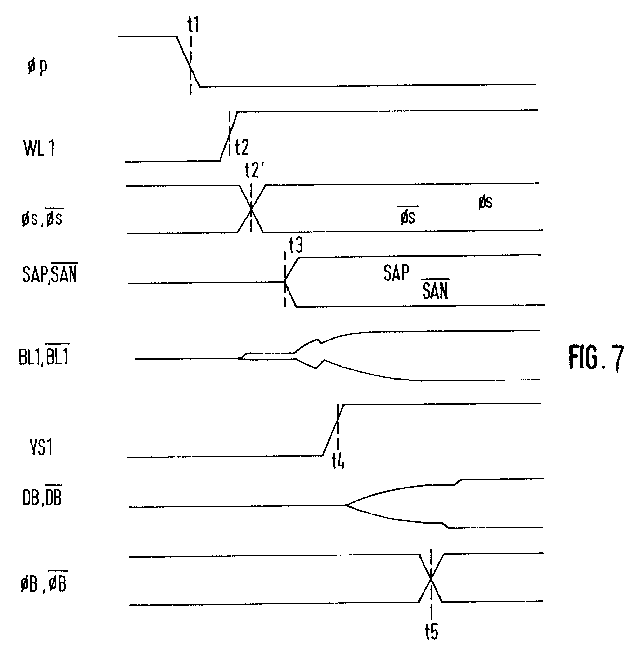

With reference to Figs. 6 and 7, the semiconductor memory device according to another embodiment of the present invention will be explained.

This embodiment is obtained by a precharge circuit 10˝ composed of an N-channel transistor Q₃₃ in place of the circuit 10′ of Fig. 4 and further provided with a data amplifier BA having a CMOS type flip-flop made of P-channel transistors Q₄₁, Q₄₂ and N-channel transistors Q₄₃ and Q₄₄, and a P-channel enable transistor Q₄₅ and an N-channel enable transistor Q₄₆.

The transistor Q₃₃ shortcircuits between the pair of data lines DB, D̅B̅ in response to the high level of φ_{P} in the precharge period. Since the pair of data lines DB and D̅B̅ have almost the same capacitance and are amplified into the Vcc level and the ground level by the amplifier BA enabled in response to the high level of φ_{B} and the low level of φ̅_̅{̅B̅}̅ at a time point t₅ in Fig. 7 in the active period, the pair of data lines DB and D̅B̅ are set approximately at the 1/2 Vcc level by simply shortcircuiting them by the circuit 10˝. Also, in the respective bit line precharge circuits BP1 - BPn, the transistors Q₁₀ and Q₁₁ may be deleted by the same reason.

As set forth above, the data stored in the memory cell can effectively be fed to the data lines by precharging the cell data lines to the same 1/2 Vcc level as that of the bit lines without being destroyed even though the effective resistance of the transfer switches for electrically connecting the data lines and bit lines become abnormally high because of variations in quality or deformities of the production system, or a case where the switch is turned on while the bit line differential potential stays insufficient.

## Claims

1. A semiconductor memory device comprising a plurality of word lines (WL), a plurality of pairs of bit lines (BL) intersecting with said word lines, a plurality of memory cells (CL) coupled to said word lines and said bit lines, a plurality of sense amplifiers (SA) each having first and second input/output nodes and first and second power nodes, each of said sense amplifiers being coupled at said first and second input/output nodes thereof to each pair of bit lines and amplifying, when activated, one and the other of each pair of bit lines to first and second potentials, respectively, said first and second potentials being approximately equal to first and second power voltages (Vcc, GND), respectively, a plurality of bit line precharge circuits (BP) provided for said plurality of pairs of bit lines, each of said bit line precharge circuits operatively precharging each pair of bit lines to a third potential having an intermediate value between said first and second potentials, a pair of common data lines (DB), a column selection circuit (YSW) for selectively connecting one pair of bit lines to said pair of common data lines to thereby establish signal paths therebetween, and a data line precharge circuit (10', 10'') for operatively precharging said pair of data lines approximately at said third potential,
**characterized in** that said memory device further comprises a control circuit (14) coupled to said first and second power nodes of each of said sense amplifiers and supplying said first and second power nodes with said third potential when each of said sense amplifier is deactivated and with said first and second power voltages, respectively, when each of said sense amplifiers is activated.

2. The semiconductor memory device according to claim 1, in which each of said memory cells (22) includes a storage capacitor (C_{M}) and a transfer gate transistor (Q_{M}) coupled between said storage capacitor and one of said bit lines.

3. The semiconductor memory device according to claim 1, in which said data line precharge circuit (10′, 10˝) includes means (Q₃₃) for operatively shortcircuiting said pair of data lines.

4. The semiconductor memory device according to claim 1, in which each of said bit line precharge circuits (BP) includes means (Q₁₂) for operatively shortcircuiting the associated pair of bit lines.

5. The semiconductor memory device according to claim 1, in which each of said sense amplifiers (SA) includes a CMOS type flip-flop.

6. The semiconductor memory device according to claim 1, further comprising a data amplifier (BA) for operatively amplifying potentials of said pair of data lines to said first and second potentials.

7. The semiconductor memory device according to claim 1, in which said column selection circuit (YSW) includes a plurality of pairs of transfer gates (Q8, Q9) coupled between said plurality of pairs of bit lines and said pair of common data lines, and means (12) for selcetively enabling one pair of said transfer gates.

8. The semiconductor memory device according to claim 1,
**characterized in** that said control circuit (14) includes a first line (SAP) connected in common to said first power nodes of said sense amplifiers, a second line (SAN) connected in common to said second power nodes of said sense amplifiers, a first transistor (Q17) connected between said first line and a third line (HVC) supplied with said third potential, a second transistor (Q18) connected between said second line and said third line, a third transistor (Q16) connected between said first and second lines and having a gate connected in common to the gates of said first and second transistors, a fourth transistor (Q15) connected between said first line and a fourth line supplied with said first power voltage (Vcc), and a fifth transistor (Q19) connected between said second line and a fifth line supplied with said second power voltage, said first to third transistors being turned on when each of said sense amplifiers is deactivated and said fourth and fifth transistors being turned on when each of said sense amplifiers is activated.

## Patentansprüche

1. Halbleiterspeichervorrichtung mit einer Anzahl von Wortleitungen (WL), einer Anzahl von Paaren von Bitleitungen (BL), die die Wortleitungen kreuzen, einer Anzahl von Speicherzellen (CL), die mit den Wortleitungen und den Bitleitungen gekoppelt sind, einer Anzahl von Leseverstärkern (SA) mit jeweils einem ersten und einem zweiten Eingangs-/ Ausgangs-Knoten und einem ersten und einem zweiten Versorgungsknoten, wobei jeder der Leseverstärker an seinem ersten und zweiten Eingangs-/Ausgangs-Knoten mit jedem Paar Bitleitungen verbunden ist und, wenn aktiviert, die eine und die andere Bitleitung jedes Paares auf ein erstes bzw. auf ein zweites Potential verstärkt, wobei das erste und das zweite Potential näherungsweise gleich einer ersten bzw. einer zweiten Versorgungsspannung (Vcc, GND) ist, einer Anzahl von Bitleitungs-Vorladeschaltungen (BP) für die Anzahl von Paaren von Bitleitungen, wobei jede der Bitleitungs-Vorladeschaltungen operativ jedes Paar von Bitleitungen auf ein drittes Potential vorlädt, das einen Zwischenwert zwischen dem ersten und dem zweiten Potential aufweist, einem Paar gemeinsamer Datenleitungen (DB), einer Spaltenauswahlschaltung (YSW) zum selektiven Verbinden eines Paares von Bitleitungen mit dem Paar gemeinsamer Datenleitungen, um dadurch Signalwege zwischen ihnen zu schaffen, und einer Datenleitung-Vorladeschaltung (10′, 10˝) zum operativen Vorladen des Paares von Datenleitungen näherungsweise auf das dritte Potential,
dadurch **gekennzeichnet,** daß die Speichervorrichtung ferner eine Steuerschaltung (14) aufweist, die mit dem ersten und zweiten Versorgungsknoten jedes Leseverstärkers verbunden ist und den ersten und den zweiten Versorgungsknoten mit dem dritten Potential versorgt, wenn jeder der Leseverstärker deaktiviert ist, und mit der ersten bzw. zweiten Versorgungsspannung, wenn jeder der Leseverstärker aktiviert ist.

2. Halbleiterspeichervorrichtung nach Anspruch 1, wobei jede der Speicherzellen (22) einen Speicherkondensator (C_{M}) und einen Übertragungstor-Transistor (Q_{M}) aufweist, der zwischen den Speicherkondensator und eine der Bitleitungen geschaltet ist.

3. Halbleitervorrichtung nach Anspruch 1, wobei die Datenleitungs-Vorladeschaltung (10′, 10˝) Mittel (Q₃₃) aufweist zum operativen Kurzschließen des Paares der Datenleitungen.

4. Halbleiterspeichervorrichtung nach Anspruch 1, wobei jede Bitleitungs-Vorladeschaltung (BP) Mittel (Q₁₂) aufweist zum operativen Kurzschließen des zugeordneten Bitleitungspaares.

5. Halbleiterspeichervorrichtung nach Anspruch 1, wobei jeder der Leseverstärker (SA) ein CMOS-Flip-Flop aufweist.

6. Halbleitervorrichtung nach Anspruch 1 mit ferner einem Datenverstärker (BA) zum operativen Verstärken von Potentialen des Paares der Datenleitungen auf das erste und das zweite Potential.

7. Halbleiterspeichervorrichtung nach Anspruch 1, wobei die Spaltenauswahlschaltung (YSW) eine Anzahl von Paaren von Übertragungstoren (Q8, Q9) aufweist, die zwischen die Anzahl der Paare von Bitleitungen und das Paar gemeinsamer Datenleitungen geschaltet sind, und Mittel (12) zum selektiven Freigeben eines Paares der Übertragungstore.

8. Halbleiterspeichervorrichtung nach Anspruch 1, dadurch **gekennzeichnet,** daß die Steuerschaltung (14) eine erste Leitung (SAP) aufweist, die gemeinsam mit dem ersten Versorgungsknoten der Leseverstärker verbunden ist, eine zweite Leitung (SAN), die gemeinsam mit dem zweiten Versorgungsknoten der Leseverstärker verbunden ist, einen ersten Transistor (Q17), der zwischen die erste Leitung und eine dritte Leitung (HVC) geschaltet ist, die mit dem dritten Potential versorgt wird, einen zweiten Transistor (Q18), der zwischen die zweite Leitung und die dritte Leitung geschaltet ist, einen dritten Transistor (Q16), der zwischen die erste und die zweite Leitung geschaltet ist und ein Gate aufweist, das gemeinsam mit den Gates des ersten und des zweiten Transistors verbunden ist, einen vierten Transistor (Q15), der zwischen die erste Leitung und eine vierte Leitung geschaltet ist, die mit der ersten Versorgungsspannung (Vcc) versorgt wird, und einen fünften Transistor (Q19), der zwischen die zweite Leitung und eine fünfte Leitung geschaltet ist, die mit der zweiten Versorgungsspannung versorgt wird, wobei die ersten bis dritten Transistoren eingeschaltet werden, wenn jeder der Leseverstärker deaktiviert ist, und der vierte und der fünfte Transistor eingeschaltet werden, wenn jeder der Leseverstärker aktiviert ist.

## Revendications

1. Dispositif de mémoire à semiconducteur comprenant une pluralité de lignes de mot (WL), une pluralité de paires de lignes de bit (BL) croisant lesdites lignes de mot, une pluralité de cellules de mémoire (CL) couplées auxdites lignes de mot et auxdites lignes de bit, une pluralité d'amplificateurs de détection (SA) dont chacun comporte des premier et second noeuds d'entrée/sortie et des premier et second noeuds de puissance. chacun desdits amplificateurs de détection étant couplé auxdits premier et second noeuds d'entrée/sortie à chaque paire de lignes de bit et amplifiant respectivement, lorsqu'il est activé, l'une et l'autre de chaque paire de lignes de bit jusqu'à des premier et second potentiels, respectivement, lesdits premier et second potentiels étant approximativement égaux à des première et seconde tensions d'alimentation (Vcc, GND), respectivement, une pluralité de circuits de précharge de ligne de bit (BP) prévus pour ladite pluralité de paires de lignes de bit (BP), chacun desdits circuits de précharge de ligne de bit préchargeant en fonctionnement chaque paire de lignes de bit jusqu'à un troisième potentiel ayant une valeur intermédiaire entre lesdits premier et second potentiels, une paire de lignes de données communes (DB), un circuit de sélection de colonne (YSW) pour connecter sélectivement une paire de lignes de bit à ladite paire de lignes de données communes pour ainsi établir des voies de signal entre, et un circuit de précharge de ligne de données (10′, 10˝) pour précharger en fonctionnement ladite paire de lignes de données à approximativement audit troisième potentiel,
caractérisé en ce que ledit dispositif de mémoire comprend en outre un circuit de commande (14) couplé auxdits premier et second noeuds de puissance de chacun desdits amplificateurs de détection et appliquant auxdits premier et second noeuds de puissance, ledit troisième potentiel lorsque chacun desdits amplificateurs de détection est désactivé et lesdites première et seconde tensions d'alimentation lorsque chacun desdits amplificateurs de détection est activé.

2. Dispositif de mémoire à semiconducteur selon la revendication 1, dans lequel chacune desdites cellules de mémoire (22) inclut un condensateur de stockage (C_{M}) et un transistor de porte de transfert (Q_{M}) couplé entre ledit condensateur de stockage et l'une desdites lignes de bit.

3. Dispositif de mémoire à semiconducteur selon la revendication 1, dans lequel ledit circuit de précharge de ligne de données (10′, 10˝) inclut des moyens (Q₃₃) pour court-circuiter en fonctionnement ladite paire de lignes de données.

4. Dispositif de mémoire à semiconducteur selon la revendication 1, dans lequel chacun desdits circuits de précharge de ligne de bit (BP) inclut des moyens (Q₁₂) pour court-circuiter en fonctionnement la paire associée de lignes de bit.

5. Dispositif de mémoire à semiconducteur selon la revendication 1, dans lequel chacun desdits amplificateurs de détection (SA) inclut une bascule bistable de type CMOS.

6. Dispositif de mémoire à semiconducteur selon la revendication 1, comprenant en outre un amplificateur de données (BA) pour amplifier en fonctionnement des potentiels de ladite paire de lignes de données jusqu'auxdits premier et second potentiels.

7. Dispositif de mémoire à semiconducteur selon la revendication 1, dans lequel ledit circuit de sélection de colonne (YSW) inclut une pluralité de paires de portes de transfert (Q8, Q9) couplées entre ladite pluralité de lignes de bit et ladite paire de lignes de données communes et des moyens (12) pour valider sélectivement une paire desdites portes de transfert.

8. Dispositif de mémoire à semiconducteur selon la revendication 1, caractérisé en ce que ledit circuit de commande (14) inclut une première ligne (SAP) connectée en commun auxdits premiers noeuds de puissance desdits amplificateurs de détection, une seconde ligne (SAN) connectée en commun auxdits seconds noeuds de puissance desdits amplificateurs de détection, un premier transistor (Q17) connecté entre ladite première ligne et une troisième ligne (HVC) alimenté par ledit troisième potentiel, un second transistor (Q18) connecté entre ladite seconde ligne et ladite troisième ligne, un troisième transistor (Q16) connecté entre lesdites première et seconde lignes et ayant une grille connectée en commun aux grilles desdits premier et second transistors, un quatrième transistor (Q15) connecté entre ladite première ligne et une quatrième ligne alimenté par ladite première tension d'alimentation (Vcc) et un cinquième transistor (Q19) connecté entre ladite seconde ligne et une cinquième ligne alimentée par ladite seconde tension d'alimentation, lesdits premier à troisième transistors étant rendus passants lorsque chacun desdits amplificateurs de détection est désactivé et lesdits quatrième et cinquième transistors étant rendus passants lorsque chacun desdits amplificateurs de détection est activé.
